# EUROPÄISCHE PATENTSCHRIFT

(11) **EP 0 951 078 B1**
(45) Veröffentlichungstag und Bekanntmachung des Hinweises auf die Patenterteilung: **01.09.2004**
(21) Anmeldenummer: 99201104.9
(22) Anmeldetag: 08.04.1999
(51) Int. Cl.: H01L 41/09, G11B 19/00

(54) **Piezomotor**
Piezomotor
Moteur piézo

(30) Priorität: 17.04.1998 DE 19817038
(43) Veröffentlichungstag der Anmeldung: 20.10.1999
(73) Patentinhaber: Philips Intellectual Property & Standards GmbH, 20099 Hamburg (DE); Koninklijke Philips Electronics N.V., 5621 BA Eindhoven (NL)
(72) Erfinder: Dettmann, Norbert, Röntgenstrasse 24, 22335 Hamburg (DE); Diefenbach, Gerhard, Röntgenstrasse 24, 22335 Hamburg (DE); Küppers, Franz-Josef, Röntgenstrasse 24, 22335 Hamburg (DE); Reichinger, Christian, Dr., Röntgenstrasse 24, 22335 Hamburg (DE)
(74) Vertreter: Volmer, Georg, Dipl.-Ing.

(56) Entgegenhaltungen:
- EP-A- 0 741 420
- EP-A- 0 755 054

## Beschreibung

Die Erfindung betrifft einen Motor mit einem quaderförmigen Piezoelement gemäß dem Oberbegriff des Anspruchs 1.

Ein solcher Motor ist beispielsweise aus der EP-A 755 054 bekannt. Ein derartiger Motor wird beispielsweise in CD-Laufwerken eingesetzt zum Antrieb einer Welle, auf der ein mit einem Lese-/Schreibkopf versehener Arm sitzt, der in radialer Richtung über die CD bewegt werden soll. Das als rechteckförmige Platte ausgebildete Piezoelement weist einen Stößel auf, mit dem eine Kraft auf die Welle in Stoßrichtung übertragen werden kann, wodurch die Welle angetrieben wird. Das Piezoelement ist dabei so ausgebildet und wird derart angesteuert, daß es in einer Schwingungsebene schwingt, in der auch die Stoßrichtung liegt, und daß der Stößel sich in etwa auf einer elliptischen Kurve bewegt.

Bei dem bekannten Motor ist das Piezoelement durch vier Einspannelemente eingespannt, wobei zwei steif ausgebildete Einspannelemente auf eine erste Mantelfläche des Piezoelements wirken, welche senkrecht zur Schwingungsebene und parallel zur Stoßrichtung liegt, und zwei federnd ausgebildete Einspannelemente auf die gegenüberliegende Mantelfläche wirken. Durch die federnden Einspannelemente wird eine Vorspannung zwischen dem Piezoelement und einem Motorengehäuse bewirkt, um zu verhindern, daß das in zur Schwingungsebene senkrechter Richtung verhältnismäßig dünn ausgebildete Piezoelement um eine zur Stoßrichtung senkrechte oder parallele Achse rotieren und seine Lage verändern kann. Die federnden Einspannelemente führen jedoch auch dazu, daß zwischen allen Einspannelementen und dem Piezoelement eine Reibkraft auftritt, durch die die Schwingungsgüte und damit die Leistung des Motors reduziert werden.

Der vorliegenden Erfindung liegt demnach die Aufgabe zugrunde, den bekannten Motor hinsichtlich der genannten Nachteile zu verbessern, insbesondere die Effizienz zu erhöhen.

Diese Aufgabe ist durch den Motor gemäß Anspruch 1 gelöst. Es wurde erkannt, daß die Güte der Schwingung des Piezoelements und damit die Leistung eines derartigen Motors dadurch erhöht werden kann, daß das Piezoelement zwar eingespannt ist, daß diese Einspannung aber möglichst gleitfähig und ohne Aufbringung einer Vorspannungskraft auf das Piezoelement in den zur Stoßrichtung senkrechten Richtungen auszubilden ist. Bei möglichst gleitfähiger Einspannung können auch keine Reibkräfte zwischen dem Piezoelement und den Einspannelementen auftreten, die die Güte der Schwingung vermindern könnten. Erfindungsgemäß können Einspannelemente somit in der Schwingungsebene als auch außerhalb der Schwingungsebene (z.B. in einer zur Schwinungsebene senkrechten Ebene oder unter einem Winkel zur Schwinungsebene verlaufenden Ebene) als auch in mehreren solcher Ebenen liegen. Wesentlich ist die Eigenschaft der Einspannelemente, daß die Einspannung möglichst gleitfähig und ohne Aufbringung einer Vorspannkraft in zur Stoßrichtung senkrechter Richtung erfolgt.

Vorteilhafte Ausgestaltungen der Einspannelemente sind in den Ansprüchen 2 bis 5 angegeben, wobei die Ausgestaltung gemäß Anspruch 2 besonders vorteilhaft ist. Bei dieser Ausgestaltung sind die bei dem bekannten Motor vorgesehenen Einspannelemente vollständig weggelassen und stattdessen Einspannelemente auf den sich parallel zur Schwingungsebene erstreckenden Mantelflächen des Piezoelements vorgesehen, die insbesondere verhindern, daß das Piezoelement um eine senkrecht oder parallel zur Stoßrichtung in der Schwingungsebene verlaufende Achse rotieren kann.

Weitere Ausgestaltungen des Motors gemäß den Ansprüchen 6 bis 8 ermöglichen eine einfachere und kostengünstigere Herstellbarkeit des Motors durch Verwendung von weniger und einfacher herzustellenden Einzelteilen. Auch die Anbringung von elektrischen Anschlüssen an die Ansteuerelektroden des Piezoelements ist dabei einfacher möglich.

Ein solcher Motor kann dazu verwendet werden, ein bewegliches Element in zur Stoßrichtung senkrechter Richtung zu bewegen oder ein drehbares Element um eine zur Schwingungsebene senkrecht verlaufende Drehachse anzutreiben. Anwendungsmöglichkeiten bieten sich beispielsweise bei Laufwerken zum Antrieb der Lese- und/oder Schreibeinheit, insbesondere bei optischen Laufwerken wie CD- oder DVD-Laufwerken, bei denen mit möglichst hoher Geschwindigkeit bei gleichzeitig geringem Platz- und Leistungsbedarf die optische Einheit in radialer Richtung über den optischen Datenträger bewegt werden muß. Andere Einsatzmöglichkeiten bieten sich überall dort, wo die von herkömmlichen Elektromotoren erzeugten Magnetfelder die Gerätefunktion stören können, wie beispielsweise bei medizinischen Anwendungen (z.B. in einem Kernspintomographen), oder wo solche Magnetfelder aus anderen Gründen unerwünscht sind, wie beispielsweise bei Rasierapparaten.

Die Erfindung wird nachfolgend anhand der Zeichnung näher erläutert. Es zeigen:
- Fig. 1A: einen bekannten Motor,
- Fig. 1B: einen erfindungsgemäßen Motor,
- Fig. 1C, 1D: den Schwingungsverlauf bei einem erfindungsgemäßen Motor,
- Fig. 2: eine Ausgestaltung des erfindungsgemäßen Motors,
- Fig. 3: ein CD-Laufwerk mit einem erfindungsgemäßen Motor,
- Fig. 4: eine weitere Ausführung eines CD-Laufwerks mit erfindungsgemäßen Motor und
- Fig. 5: eine dritte weitere Ausführung eines CD-Laufwerks mit erfindungsgemäßen Motor.

Fig. 1A zeigt einen bekannten Motor mit einem Piezoelement 1, das an einer ersten Mantelfläche 10 einen Stößel 2 und an einer zweiten, der ersten Mantelfläche 10 gegenüberliegenden Mantelfläche 9 ein Vorspannelement 3, beispielsweise eine Feder, aufweist, welches das Piezoelement 1 gegen das Motorengehäuse 8 vorspannt in Stoßrichtung (= x-Richtung). Zwei federnde Einspannelemente 4, 5 sind zwischen Gehäuse 8 und Mantelfläche 15 des Piezoelements 1 angeordnet und erzeugen eine Vorspannkraft in y-Richtung. Zwei steife Einspannelemente 6, 7 sind zwischen Gehäuse 8 und gegenüberliegender Mantelfläche 16 angeordnet. Auf der Oberseite 17 des Piezoelements 1 sind vier Ansteuerelektroden 11,12,13,14 flächig angebracht, auf der gegenüberliegenden Unterseite des Piezoelements 1 ist eine gemeinsame Bezugselektrode angebracht (nicht sichtbar). Die Polarisierungsrichtung des Piezoelements 1 unterhalb der Ansteuerelektroden 11,12,13,14 ist überall gleich. Mittels (nicht gezeigten) Ansteuerungsmitteln wird das Piezoelement 1 über die Ansteuerelektroden 11,12,13,14 so angesteuert, daß das Piezoelement 1 in der Schwingungsebene (x/y-Ebene) schwingt, wobei die Schwingung sich als Überlagerung zweier orthogonaler Schwingungen (in x- bzw. y-Richtung) ergibt. Durch geeignete Ansteuerung und durch geeignete Wahl der Geometrie des Piezoelements 1 können die Resonanzfrequenzen der beiden orthogonalen Schwingungen so eingestellt werden, daß beide Schwingungen mit ausreichender Amplitude und gewünschter Phasenlage angeregt werden und daß der Stößel 2 sich beispielsweise auf einer in der x/y-Ebene liegenden Kurve, insbesondere auf einer ellipsenförmigen Kurve E, deren große Achse einenWinkel von z.B. 30° mit der x-Achse bildet, bewegt und dabei das Element 19 in y-Richtung durch Stoßen gegen das Element 19 bewegt.

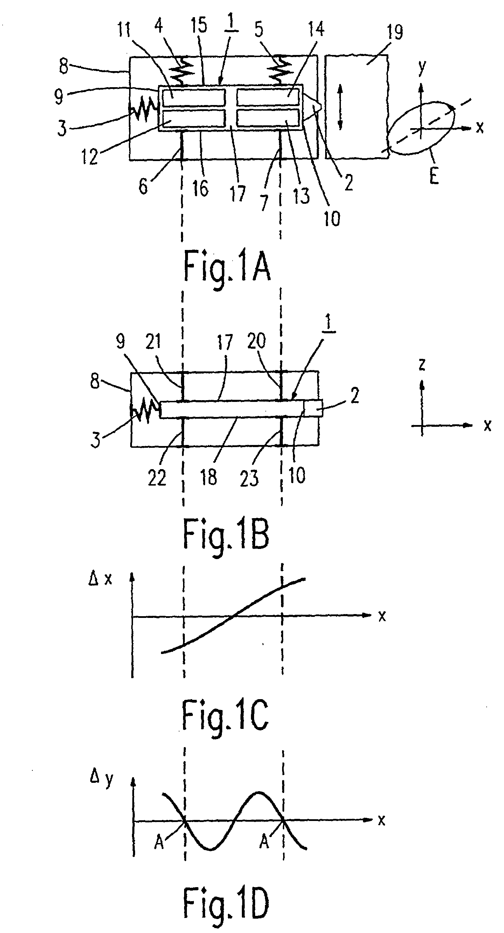

Ein erfindungsgemäßer Motor ist in Fig. 1B gezeigt, der statt der Einspannelemente 4,5,6,7 in z-Richtung verlaufende steife Einspannelemente 20,21,22,23 aufweist. Diese bewirken lediglich eine Einspannung des Piezoelements 1 in z-Richtung, ohne jedoch Vorspannungskräfte auf dieses aufzubringen. Es wird jedoch eine Rotation des Piezoelements 1 sowohl um eine in y-Richtung als auch um eine in x-Richtung verlaufende Achse verhindert, was bei der bekannten Anordnung gemäß Fig. 1a durch die Vorspannung mittels der Einspannelemente 4,5 gelöst wurde. Auch wenn die Einspannelemente 20,21,22,23 sich nahezu über die ganze Breite (in y-Richtung) des Piezoelements 1 erstrecken, treten kaum Reibungskräfte an den Berührungsstellen zwischen den Einspannelementen 20,21,22,23 und den Mantelflächen 17 bzw. 18 des Piezoelements 1 auf, da die Einspannung gleitend ausgeführt ist. Dadurch läßt sich eine höhere Schwingungsgüte erreichen, so daß der Wirkungsgrad des erfindungsgemäßen Motors deutlich höher ist und ggf. die zum Betrieb des Motors erforderliche Spannung verringert werden kann.

Fig. 1C und 1D zeigen den Verlauf der Amplituden der beiden orthogonalen Schwingungen in x- bzw. y-Richtung bei Betrieb des Motors entlang der Längsrichtung x des Piezoelements 1. Fig. 1C zeigt den Verlauf der Transversalschwingung, Fig. 1D zeigt den Verlauf der Longitudinalschwingung. Durch Überlagerung der beiden Schwingungen ergibt sich die oben beschriebene elliptische Kurve, auf der sich der Stößel 2 bewegt. Sowohl bei dem bekannten Motor als auch bei dem erfindungsgemäßen Motor sind die Einspannelemente in den Schwingungsknoten A angeordnet, d.h. an Stellen in x-Richtung, an denen die Schwingung in y-Richtung eine Nullstelle hat. Bei Betrieb des Motors verändert sich jedoch die Position der Schwingungsknoten in x-Richtung. Diese Bewegung wird aufgrund der federnden Einspannung durch die Einspannelemente 4,5 bei der bekannten Anordnung gehemmt, was zu Verlusten des Wirkungsgrades führt, während bei der erfindungsgemäßen Anordnung aufgrund der gleitenden Ausführung der Einspannelemente 20,21,22,23 diese Bewegung nicht behindert wird und deshalb ein höherer Wirkungsgrad des Motors möglich ist.

Bei der in Fig. 1B gezeigten Ausführungsform mit Einspannelementen 20,21,22,23 in z-Richtung können zusätzlich auch ein oder mehrere, die Bewegung des Piezoelements 1 in y-Richtung begrenzende Anschlagelemente vorgesehen sein. Alternativ zu der in Fig. 1B gezeigten Ausführungsform ist auch eine Ausführung der Erfindung möglich mit vier in y-Richtung steifen Einspannelementen statt der vier in z-Richtung steifen Einspannelemente 20,21,22,23, wobei dann bevorzugt ein oder mehrere die Bewegung des Piezoelements in y-Richtung begrenzende Anschlagelemente vorgesehen sind.

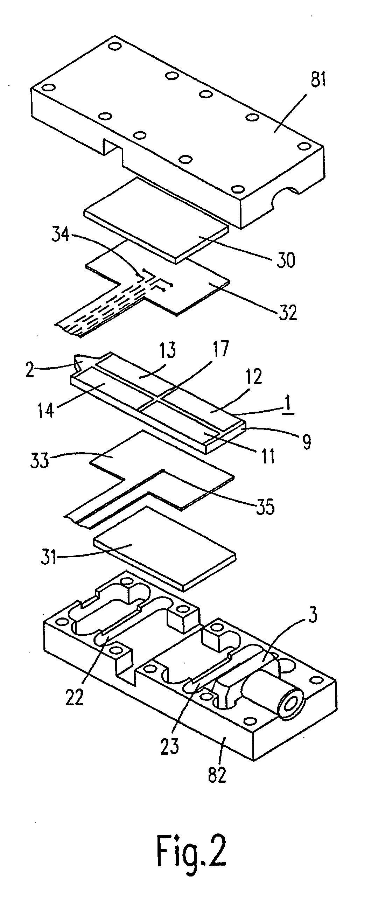

Eine mögliche Ausgestaltung des erfindungsgemäßen Motors ist in Fig. 2 gezeigt. In das aus zwei Gehäuseteilen 81,82 bestehende Gehäuse sind die Einspannelemente 20 bis 23 (gezeigt sind nur die Elemente 22,23) bereits integriert. Das Vorspannelement 3 ist als in das Gehäuseteil 82 eingelegtes Gummiteil realisiert. Das Piezoelement 1 ist auf seinen Mantelflächen 17 bzw. 18 von jeweils einer Leiterbahnfolie 32 bzw. 33 bedeckt, die Kontaktierungsmittel 34,35 zur elektrischen Kontaktierung mit den Ansteuerelektroden 11 bis 14 bzw. der Bezugselektrode (nicht gezeigt) und entsprechende Zuleitungen zu den Kontaktierungsmitteln 34, 35 tragen. Vorzugsweise sind die Kontakte 34 ebenfalls in der Nähe der Schwingungsknoten angeordnet, womit die höchsten Werte für die Schwingungsgüte erzielt werden können. Die Kontaktierungspunkte 34 können jedoch auch wie gezeigt in etwa in der Mitte des Piezoelements 1 angeordnet sein, wo auch der Kontaktierungspunkt 35 angeordnet ist. Die Verwendung solcher Leiterbahnfolien 32, 33 ist einfacher und kostengünstiger als die grundsätzlich auch mögliche Verwendung von auf die Elektroden aufgeklebten oder aufgelöteten Drähten.

Es können zusätzlich noch weitere Anpreßteile 30,31 vorgesehen sein, die eine ausreichende Anpreßkraft aufbringen, mit welcher die Leiterbahnfolien 32,33 gegen das Piezoelement 1 gedrückt werden, um eine stabile Kontaktierung zu schaffen.

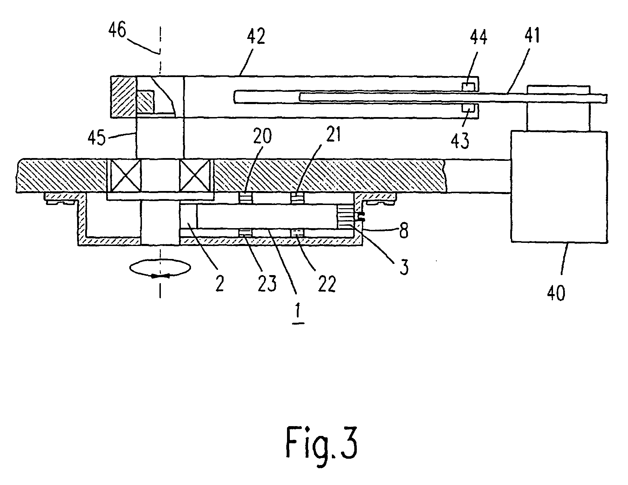

Die Anwendung eines erfindungsgemäßen Motors bei einem CD-Laufwerk ist in Fig. 3 dargestellt. Bei solchen Laufwerken muß ein mit einem Lese-/Schreibkopf 43, 44 versehener Arm 42 in radialer Richtung über eine CD 41 bewegt werden, welche von einem Motor 40 angetrieben ist. Der Arm 42 ist auf einer um eine Drehachse 46 drehbaren Welle 45 angeordnet, die von einem erfindungsgemäßen Motor angetrieben wird. Dazu ist in einem Gehäuseteil 8 ein Piezoelement 1 angeordnet, das durch steife Einspannelemente 20,21,22,23 eingespannt und durch ein Vorspannelement 3 gegen die Welle 45 vorgespannt ist. Über den Stößel 2 wird eine Kraft auf die Welle 45 übertragen, welche dadurch je nach Ansteuerung des Piezoelements 1 in beiden Drehrichtungen drehbar ist, so daß sich der Arm 42 in der gewünschten Richtung über die CD 41 bewegt.

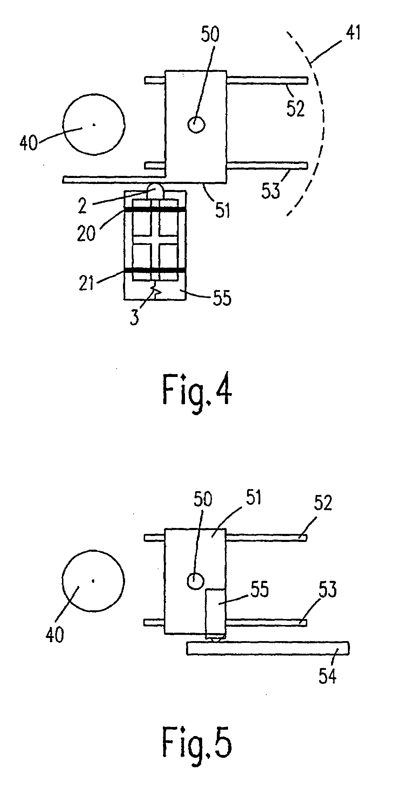

Fig. 4 zeigt eine weitere Ausführungsform eines CD-Laufwerks mit einem erfindungsgemäßen Motor 55. Dabei ist der Lese-/Schreibkopf hinter einer Linse 50 verborgen. Die gesamte Lese-/Schreibeinheit ist auf einem Schlitten 51 untergebracht und wird von dem erfindungsgemäßen Motor 55 entlang zweier Führungen 52, 53 linear in radialer Richtung der CD 41 bewegt. Dabei kann der Motor 55 fest im Gehäuse des CD-Laufwerks eingebaut sein und über den Stößel 2 auf den Schlitten 51 stoßen und diesen bewegen.

Eine weitere Ausführungsform ist in Fig. 5 gezeigt, bei der der Motor 55 auf dem Schlitten 51 angebracht ist. Der Stößel 2 stößt gegen ein Teil des Laufwerksgehäuses 54, und Motor 55 und Schlitten 51 bewegen sich gemeinsam.

## Patentansprüche

1. Motor mit einem quaderförmigen Piezoelement (1), mit Mitteln (3, 11, 12, 13, 14) zur Erzeugung einer Schwingung des Piezoelements (1) in einer Schwingungsebene (x/y-Ebene), wobei an einer zu einer Stoßrichtung (x) des Piezoelements (1) senkrechten Mantelfläche (10) des Piezoelements (1) ein Stößel (2) zum Übertragen einer Kraft in Stoßrichtung (x) und an dessen gegenüberliegender Mantelfläche (9) ein Vorspannelement (3) zum Aufbringen einer Vorspannkraft angeordnet sind,
**dadurch gekennzeichnet, dass** das Piezoelement (1) mittels steifen Einspannelementen (20, 21, 22, 23) vorspannungsfrei und gleitend in den zur Stoßrichtung (x) senkrechten Richtungen (y, z) eingespannt ist.

2. Motor nach Anspruch 1,
**dadurch gekennzeichnet, daß** auf jeder sich parallel zur Schwingungsebene (x/y-Ebene) erstreckender Mantelfläche (17, 18) des Piezoelements (1) jeweils mindestens zwei steife Einspannelemente (20, 21, 22, 23) angeordnet sind.

3. Motor nach Anspruch 1,
**dadurch gekennzeichnet, daß** sich die Einspannelemente (20, 21, 22, 23) in etwa über die Breite des Piezoelements (1) erstrecken.

4. Motor nach Anspruch 1,
**dadurch gekennzeichnet, daß** auf jeder sich senkrecht zur Schwingungebene (x/y-Ebene) erstreckender und parallel zur Stoßrichtung (x) verlaufender Mantelfläche (15, 16) des Piezoelements (1) jeweils mindestens zwei steife Einspannelemente angeordnet sind.

5. Motor nach Anspruch 1,
**dadurch gekennzeichnet, daß** die Einspannelemente (20, 21, 22, 23) in den Schwingungsknoten (A) der in Stoßrichtung (x) verlaufenden transversalen Schwingung des Piezoelements (1) angeordnet sind.

6. Motor nach Anspruch 1,
**dadurch gekennzeichnet, daß** die Einspannelemente (20, 21, 22, 23) in ein das Piezoelement (1) umschließendes Gehäuse (8; 81, 82) integriert sind.

7. Motor nach Anspruch 1,
**dadurch gekennzeichnet, daß** das Vorspannelement (3) und/oder Kontaktierungsmittel (34, 35) für das Piezoelement (1) in das Gehäuse (8; 81, 82) integriert sind.

8. Motor nach Anspruch 1,
**dadurch gekennzeichnet, daß** das Piezoelement (1) auf einer sich parallel zur Schingungsebene (x/y-Ebene) erstreckenden Mantelfläche (17) vier Ansteuerelektroden (11, 12, 13, 14) aufweist und daß vier Kontaktelemente (34) für die Ansteuerelektroden (11, 12, 13, 14) etwa in den Schwingungsknoten (A) der in Stoßrichtung (x) verlaufenden transversalen Schwingung des Piezoelements (1) oder etwa mittig zwischen den Mantelflächen (9, 10) des Piezoelements (1) angeordnet sind.

9. Verwendung des Motors nach Anspruch 1 zum Antrieb eines Elements (19) in zur Stoßrichtung (x) senkrechter Richtung (y) oder eines um eine senkrecht zur Schwingungsebene (x/y-Ebene) verlaufende Drehachse (46) drehbaren Elements (42).

10. Laufwerk zum Lesen und/oder Schreiben von Informationen von einem bzw. auf einen Datenträger, insbesondere einen optischen Datenträger wie eine CD oder eine DVD, mit einer Lese- und/oder Schreibeinheit (43, 44),
**dadurch gekennzeichnet, daß** das Laufwerk einen Motor nach Anspruch 1 aufweist zum Antrieb der Lese- und/oder Schreibeinheit (43, 44).

## Claims

1. A motor having a cuboid piezoelectric element (1) having means (3, 11, 12, 13, 14) for exciting a vibration of the piezoelectric element (1) in a plane of vibration (x/y plane), a bounding surface (10) of the piezoelectric element (1), which bounding surface extends perpendicularly to an actuating direction (x) of the piezoelectric element (1), carrying an actuating member (2) for transmitting a force in the actuating direction (x), and a bounding surface (9) opposite said first-mentioned bounding surface (10) carrying a preloading element (3) for applying a preloading force,
**characterized in that** the piezoelectric element (1) is restrained in directions (y, z) perpendicular to the actuating direction (x) without preloading and in a sliding manner by means of restraining elements (20, 21, 22, 23).

2. A motor as claimed in Claim 1,
**characterized in that** at least two rigid restraining elements (20, 21, 22, 23) are arranged on each of the bounding surfaces (17, 18) of the piezoelectric element (1) which extend parallel to the plane of vibration (x/y plane).

3. A motor as claimed in Claim 1,
**characterized in that** the restraining elements (20, 21, 22, 23) extend substantially across the width of the piezoelectric element (1).

4. A motor as claimed in Claim 1,
**characterized in that** at least two rigid restraining elements are arranged on each of the bounding surfaces (15, 17) of the piezoelectric element (1) which extend perpendicularly to the plane of vibration (x/y plane) and parallel to the actuating direction (x).

5. A motor as claimed in Claim 1,
**characterized in that** the restraining elements (20, 21, 22, 23) are disposed in the vibration nodes (A) of the transverse wave of the piezoelectric element (1), which transverse wave travels in the actuating direction (x).

6. A motor as claimed in Claim 1,
**characterized in that** the restraining elements (20, 21, 22, 23) have been integrated in a housing (8; 81, 82) which accommodates the piezoelectric element (1).

7. A motor as claimed in Claim 1,
**characterized in that** the preloading elements (3) and/or contact means (34, 45) for the piezoelectric element (1) have been integrated in the housing (8; 81, 82).

8. A motor as claimed in Claim 1,
**characterized in that**, on a bounding surface (17) which extends parallel to the plane of vibration (x/y plane), the piezoelectric element (1) carries four control electrodes (11, 12, 13, 14), and **in that** four contact elements (34) for the control electrodes (11, 12, 13, 14) are disposed substantially in the vibration nodes (A) of the transverse wave of the piezoelectric element (1), which transverse wave travels in the actuating direction (x), or are disposed substantially halfway between the bounding surfaces (9, 10) of the piezoelectric element (1).

9. A use of the motor as claimed in Claim 1 for driving an element (19) in a direction (y) perpendicular to the actuating direction (x) or an element (42) which is rotatable about an axis of rotation (46) which extends perpendicularly to the plane of vibration (x/y plane).

10. A drive apparatus for reading and/or writing information from/on a data carrier, particularly an optical data carrier such as a CD or a DVD that comprises a read and/or write unit (43, 44),
**characterized in that** the drive apparatus comprises a motor as claimed in Claim 1 for driving the read and/or write unit (43, 44).

## Revendications

1. Moteur avec un élément piézo-électrique parallélépipédique (1), avec des moyens (3, 11, 12, 13, 14) pour la production d'une oscillation de l'élément piézo-électrique (1) dans un plan d'oscillation (plan x/y), dans lequel un coulisseau (2) est disposé sur une surface périphérique (10) de l'élément piézo-électrique (1) perpendiculaire à une direction de poussée (x) de l'élément piézo-électrique pour la transmission d'une force dans la direction de la poussée (x) et un élément de précontrainte (3) est disposé sur sa surface périphérique (9) opposée pour l'application d'une force de précontrainte, **caractérisé en ce que** l'élément piézo-électrique (1) est fixé à l'aide d'éléments de fixation rigides (20, 21, 22, 23) sans précontrainte et à coulissement dans les directions (y, z) perpendiculaires à la direction de la poussée (x).

2. Moteur selon la revendication 1, **caractérisé en ce qu'**au moins deux éléments de fixation rigides (20, 21, 22, 23) sont disposés respectivement sur chaque surface périphérique (17, 18) de l'élément piézo-électrique (1) s'étendant parallèlement au plan d'oscillation (plan x/y).

3. Moteur selon la revendication 1, **caractérisé en ce que** les éléments de fixation (20, 21,22, 23) s'étendent à peu près sur la largeur de l'élément piézo-électrique (1).

4. Moteur selon la revendication 1, **caractérisé en ce qu'**au moins deux éléments de fixation rigides sont disposés sur chaque surface périphérique (15, 16) de l'élément piézo-électrique (1) s'etendant perpendiculairement au plan d'oscillation (plan x/y) et parallèlement à la direction de la poussée (x).

5. Moteur selon la revendication 1, **caractérisé en ce que** les éléments de fixation (20, 21, 22, 23) sont disposés dans les noeuds d'oscillation (A) de l'oscillation transversale de l'élément piézo-électrique (1) s'étendant dans la direction de la poussée (x).

6. Moteur selon la revendication 1, **caractérisé en ce que** les éléments de fixation (20, 21, 22, 23) sont intégrés dans un boîtier (8; 81, 82) renfermant l'élément piézo-électrique (1).

7. Moteur selon la revendication 1, **caractérisé en ce que** l'élément de précontrainte (3) et/ou les moyens de contact (34, 35) pour l'élément piézo-électrique (1) sont intégrés dans le boîtier (8; 81, 82).

8. Moteur selon la revendication 1, **caractérisé en ce que** l'élément piézo-électrique (1) présente quatre électrodes d'excitation (11, 12, 13, 14) sur une surface périphérique (17) s'étendant parallèlement au plan d'oscillation (plan x/y) et que quatre éléments de contact (34) sont disposés pour les électrodes d'excitation (11, 12, 13, 14) presque dans les noeuds d'oscillation (A) de l'oscillation transversale de l'élément piézo-électrique (1) s'étendant dans la direction de la poussée (x) ou à peu près au milieu entre les surfaces périphériques (9, 10) de l'élément piézo-électrique (1).

9. Mise en oeuvre du moteur selon la revendication 1 pour l'entraînement d'un élément (19) dans une direction (y) perpendiculaire à la direction de la poussée (x) ou d'un élément (42) tournant autour d'un axe de rotation (46) s'étendant perpendiculairement au plan d'oscillation (plan x/y).

10. Mécanisme d'entraînement pour la lecture et/ou l'écriture d'informations d'un ou sur un support de données, en particulier un support de données optique comme un CD ou un DVD, avec une unité de lecture et/ou d'écriture (43, 44), **caractérisé en ce que** le mécanisme d'entraînement présente un moteur selon la revendication 1 pour l'entraînement de l'unité de lecture et/ou d'écriture (43, 44).
